# FASCICULE DE BREVET EUROPEEN

(11) **EP 2 741 520 B1**
(45) Date de publication et mention de la délivrance du brevet: **16.03.2016**
(21) Numéro de dépôt: 12306514.6
(22) Date de dépôt: 04.12.2012
(51) Int. Cl.: H04Q 9/00, G01R 22/06, G01R 22/10

(54) **Module domotique à câblage traversant surveillé**
Haustechnikmodul mit überwachter durchgehender Verkabelung
Home-automation module with monitored through wiring

(43) Date de publication de la demande: 11.06.2014
(73) Titulaire: HAGER CONTROLS (Société par Actions Simplifiée), 67700 Saverne (FR)
(72) Inventeur: Lugbull, Pierre Alain, 67700 Otterswiller (FR); Colinmaire, Thierry, 57370 Saint Jean Kourtzerode (FR)
(74) Mandataire: Nuss, Laurent

(56) Documents cités:
- EP-A2- 1 340 986
- GB-A- 2 409 048

## Description

La présente invention relève du domaine des équipements pour installations électriques domestiques, et a pour objet un module domotique particulier.

Dans les installations électriques classiques, la consommation d'électricité est relevée et suivie au niveau de l'installation globale elle-même, grâce à un compteur central, et il peut alors être particulièrement difficile de relever la consommation pour certains composants de l'installation seulement, ce qui peut être toutefois intéressant pour optimiser la consommation d'énergie électrique globale.

En outre, il peut être nécessaire de suivre un autre paramètre que le courant circulant dans la ligne, et il est donc souhaitable, de façon globale, de réussir à effectuer une surveillance du fonctionnement d'une sous partie de l'installation électrique.

Relever précisément la consommation d'une branche de l'installation, ou un autre paramètre de son fonctionnement, peut être d'autant plus délicat lorsqu'il s'agit de suivre un consommateur piloté par une centrale domotique que comprend l'installation, par exemple un volet roulant, une centrale électrique de chauffage, etc.

Ce genre de consommateur électrique contrôlé par de la domotique nécessite généralement l'utilisation d'un module domotique, qui permet, entre autres, de recevoir des instructions pour le consommateur, voire de les générer tout seul, puis de piloter en conséquence la ligne électrique dans laquelle se trouve le consommateur. Bien entendu, il peut servir à prendre le contrôle de plusieurs lignes, voire à faire circuler différents signaux. Pour le câblage des lignes de puissance, un tel module domotique présente ainsi des bornes, qui sont configurées de sorte que les premières bornes dans le module sont côte à côte, et les deuxièmes bornes sont elles aussi côte à côte. Le courant de puissance circule alors d'une face du module à une autre, ce qui est cohérent avec le principe de câblage auquel l'installateur est bien souvent accoutumé.

Afin de proposer un moyen simple de surveiller le fonctionnement d'une partie de l'installation, tout en limitant les modifications à apporter tant aux câblages qu'aux composants de l'installation, l'invention propose de suivre le fonctionnement, en particulier la consommation électrique, le courant électrique ou autre, d'une partie de l'installation en aménageant, dans un tel module domotique, entre la deuxième borne et la première borne, un moyen de mesure électrique.

Le document EP 1 340 986 décrit un tableau de distribution qui permet de remplacer facilement un Wattmètre.

A cet effet, l'invention a pour objet un module domotique, présentant, d'une part, une partie puissance comprenant au moins une ligne de puissance ayant, pour sa connexion, une première borne et une deuxième borne, et, d'autre part, une partie de contrôle pour piloter au moins un composant de contrôle, type relais, monté dans la ligne de puissance et en influençant l'état électrique, en particulier l'état passant ou non.

Ce module est caractérisé en ce que
la première borne et la deuxième borne sont positionnées en vis-à-vis l'une de l'autre sur des faces opposées du module domotique, le module domotique comprenant, pour la au moins une ligne de puissance, un moyen de mesure électrique monté dans la au moins une ligne de puissance entre la première borne et la deuxième borne.

L'invention sera mieux comprise, grâce à la description ci-après, qui se rapporte à un mode de réalisation préféré, donné à titre d'exemple non limitatif, et expliqué avec référence aux dessins schématiques annexés, dans lesquels :
- la figure 1 montre un module domotique partiellement ouvert, de conception classique ;
- la figure 2 montre une carte fille sur laquelle sont montés un relais ainsi qu'un tore de mesure ;
- les figures 3 et 4 montrent la carte fille montée sur la carte mère, avec deux bornes ;
- les figures 5 et 6 illustre un montage tête bêche pour deux lignes de puissance, et
- la figure 7 montre un autre mode de réalisation de la carte fille.

L'invention a donc pour objet un module domotique 1, présentant, d'une part, une partie puissance 2 comprenant au moins une ligne de puissance 3 ayant, pour sa connexion, une première borne 4 et une deuxième borne 5, et, d'autre part, une partie de contrôle 7 pour piloter au moins un composant de contrôle 8, type relais, monté dans la ligne de puissance 3 et en influençant l'état électrique, en particulier l'état passant ou non. Classiquement, le composant de contrôle 8 prend la forme d'un relais, la ligne de puissance 3 pouvant donc se trouver dans deux états distincts, à savoir soit passante, soit non passante. Les premières bornes 4 et deuxième bornes 5 servent à la connexion de conducteurs souvent filaires. Chacune d'elle peut servir de borne d'entrée à la ligne de puissance 3 ou de borne de sortie. Des bornes sont aussi aménagées pour la connexion de la partie de contrôle 7.

Des instructions de commande sont prises en compte par la partie de contrôle 7 pour piloter le au moins un composant de contrôle 8, ce dernier faisant donc la jonction entre la partie de contrôle 7 dont il reçoit des instructions et la partie de puissance 2, puisqu'il se trouve monté dans la ligne de puissance 3. En effet, le composant de contrôle 8 est monté en série dans la ligne de puissance 3, entre la première borne 4 et la deuxième borne 5. Le module domotique 1 est donc relié à un réseau d'information au niveau des bornes de la partie de contrôle 7, ainsi qu'à l'installation de puissance, au niveau des premières bornes 4 et deuxièmes bornes 5.

Selon l'invention, la première borne 4 et la deuxième borne 5 sont positionnées en vis-à-vis l'une de l'autre sur des faces opposées du module domotique 1, le module domotique 1 comprenant, pour la au moins une ligne de puissance 3, un moyen de mesure électrique 10 monté dans la au moins une ligne de puissance 3 entre la première borne 4 et la deuxième borne 5, en particulier un moyen de mesure de courant, afin d'obtenir une mesure relative à l'ampérage qui circule dans la ligne de puissance 3.

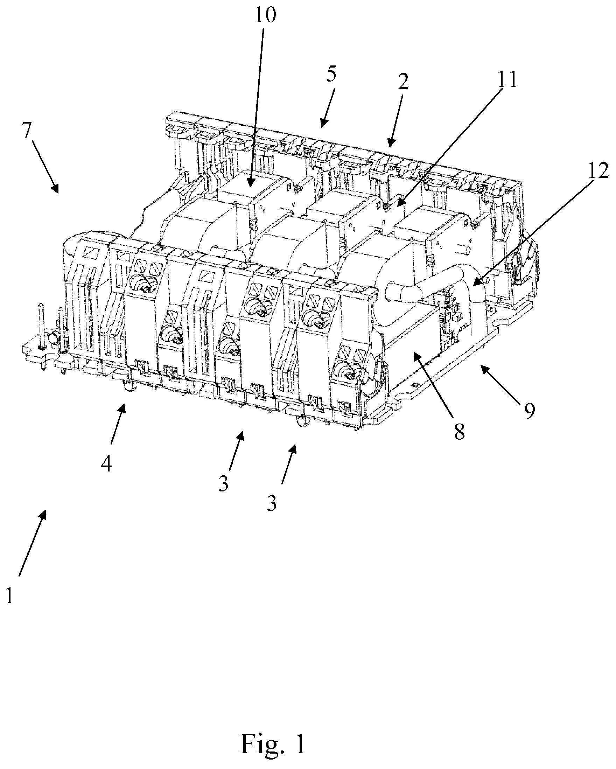

Les premières bornes 4 sont alignées les unes à côté des autres sur une face du module domotique 1, les deuxièmes bornes 5 étant alignées les unes à côté des autres sur une face du module domotique 1 parallèle à la première, comme le montre la figure 1. Ces faces sont préférentiellement horizontales une fois le module domotique 1 normalement installé. Pour une même ligne de puissance 3, la première borne 4 et la deuxième borne 5 sont donc en vis-à-vis l'une de l'autre, et non en côte à côte.

Le module domotique 1 est donc dit à câblage traversant, puisque les premières bornes 4 et les deuxièmes bornes 5 sont placées sur des faces en vis-à-vis l'une de l'autre.

L'espace dans le module domotique 1 dévolu aux différents composants de la ligne de puissance 3 entre ces deux bornes est donc limité en largeur compte tenu de la succession, l'une à côté de l'autre, de ces bornes. Les éléments propres à chaque ligne de puissance 3 sont donc eux aussi adjacents les uns aux autres, et le volume que peut occuper l'ensemble de ces éléments est naturellement limité.

Pour au moins une ligne de puissance 3, mais bien entendu préférentiellement pour chacune d'elle, le module domotique 1 a donc un composant, placé entre la première borne 4 et la deuxième borne 5, qui assure une fonction de suivi du fonctionnement de cette ligne. Préférentiellement, il assure une mesure du courant qui circule entre les bornes, bien que d'autres types de mesure soient possibles : tension, température, angle de coupure, phase, etc. Comme les lignes de puissance 3 sont alignées les unes à côté des autres dans le module domotique 1, le moyen de mesure électrique 10 est placé entre la première borne 4 et la deuxième borne 5, essentiellement dans l'alignement de ces deux bornes. Dans le cas d'une mesure de courant, le moyen de mesure électrique 10 peut prendre la forme par exemple d'un tore 14 placé électriquement en série avec le composant de contrôle 8, d'un capteur par effet hall, d'une résistance de shunt, ou autre.

La mesure effectuée par le moyen de mesure électrique 10 est naturellement transmise en aval d'un circuit de traitement d'information. Ainsi, la partie de contrôle 7 peut servir non seulement à recevoir de l'information depuis un réseau d'information du type bus domotique et à la traiter pour piloter les composants de contrôle 8, mais aussi à traiter l'information des mesures effectuées pour le suivi du comportement de la ligne de puissance 3 surveillée. Une information d'état des lignes de puissance 3 peut aussi être renvoyée sur le bus domotique auquel le module domotique 1 est connecté grâce à sa partie de contrôle 7, par exemple l'état passant ou non, ou des caractéristiques de consommation, de courant instantané, de puissance, d'énergie consommée, etc. Le traitement des valeurs mesurées peut aussi se faire directement sur le module domotique 1 : calcul de consommation moyenne, seuil d'alerte, affichage, etc. Toute sorte de calculs peuvent être réalisés sur la base des mesures, et des actions, éventuellement, préventives peuvent aussi être initiées par la partie de contrôle 7, comme l'ouverture d'un sectionneur, etc.

Selon une caractéristique additionnelle possible du module domotique 1, il comprend une première carte de circuit imprimée, dite carte mère 9, portant tout ou partie des composants électroniques du module domotique 1 ainsi que des pistes électriques pour la au moins une ligne de puissance 3 et des pistes électrique pour la partie de contrôle 7,
le moyen de mesure électrique 10 étant monté sur une deuxième carte de circuit imprimé, dite carte fille 11, que comprend le module domotique 1 et s'étendant perpendiculairement à la carte mère 9, notamment essentiellement dans l'axe première borne 4-deuxième borne 5. Les cartes mère 9 et fille 11 étant perpendiculaires, le moyen de mesure électrique 10, monté sur la carte fille 11 se trouve dans une direction perpendiculaire à celle qu'il aurait s'il était monté sur la carte mère 9.

La carte mère 9 s'étend donc préférentiellement entre la première borne 4 et la deuxième borne 5 correspondante pour chaque ligne de puissance 3, et mêle donc des pistes pour la puissance et des pistes pour un courant d'information, concerné par le pilotage du composant de contrôle 8, ou par l'information relevée par le moyen de mesure électrique 10. La carte mère 9 est préférentiellement parallèle à la façade du module domotique 1, c'est-à-dire du mur contre lequel il est normalement monté. Le moyen de mesure électrique 10 est donc monté sur une carte fille 11, connectée à la carte mère 9 et perpendiculaire à elle. Cette carte fille 11 se trouve préférentiellement sensiblement entre la première borne 4 et la première borne 5, afin de tenir compte de la largeur du module domotique 1 qui est dévolue à chacune des lignes de puissance 3.

La carte mère et la carte fille 11 sont préférentiellement reliées électriquement par soudure l'une à l'autre pour que le courant de puissance, circulant dans la ligne de puissance 3, puisse passer depuis la première borne 4, sur la carte mère 9, puis à la carte fille 11. Le courant sortant de la carte fille 11 est ensuite à nouveau envoyé à la deuxième borne 5, éventuellement à travers la carte mère 9 et/ou la carte fille 11. La piste de la carte fille 11 chargée de la circulation du courant de puissance est donc reliée aux premières bornes 4 et/ou deuxièmes bornes 5 grâce à des pistes de la carte mère 9. La jonction électrique entre la carte mère 9 et la carte fille 11 peut se faire au niveau de leur ancrage mécanique l'une à l'autre, c'est-à-dire de leur ligne de jonction. Alternativement, il est aussi possible d'utiliser une pièce intermédiaire, comme un conducteur filaire 12 qui sera encore décrit plus loin, pour relier électriquement la carte mère 9 à la carte fille 11, à l'entrée et/ou à la sortie du courant de la carte fille 11, voire directement à la première borne 4 et/ou à la deuxième borne 5. Quelle que soit la configuration, la carte fille 11 est donc reliée électriquement pour être un des composants de la ligne de puissance 3 entre la première borne 4 et la deuxième borne 5.

La carte mère 9 et la carte fille 11 sont donc par exemple reliées électriquement pour la circulation du courant de la au moins une ligne de puissance 3, de la carte mère 9 à la carte fille 11 et inversement.

Comme le moyen de mesure électrique 10 est monté sur la carte fille 11, il peut être particulièrement commode d'utiliser la carte fille 11 elle-même pour faire circuler le signal généré, représentatif de la mesure effectuée. Il peut aussi être particulièrement intéressant d'utiliser alors la partie de contrôle 7 de la carte mère 9 pour faire circuler le signal. Ainsi, la carte fille 11 est reliée électriquement à la partie de contrôle 7. Ce lien électrique peut se faire, comme pour la liaison électrique pour la puissance, au niveau de la jonction mécanique des deux cartes, par soudure directe de leurs pistes, ou grâce à un conducteur intermédiaire, type conducteur filaire ou autre, alors soudé à la fois sur la carte mère 9 et la carte fille 11.

Dans une configuration avantageuse, la carte mère 9 et la carte fille 11 sont donc reliées mécaniquement, et certaines de leurs pistes sont, en outre, reliées électriquement, pour la circulation, d'une part, du courant de puissance, et, d'autre part, du signal électrique représentant la mesure.

Selon une caractéristique additionnelle possible, le composant de contrôle 8 est lui aussi monté sur la carte fille 11, la carte mère 9 et la carte fille 11 étant, en outre, reliées électriquement pour la circulation de la commande dudit composant de contrôle 8 à l'aide de la partie de contrôle 7, notamment reliées par soudure au niveau de leur arête commune. La carte fille 11, pourvue de ses composants, forme ainsi un module qui peut venir s'insérer sur la carte mère 9 et qui porte, d'une part, la fonction de contrôle de la ligne de puissance 3, grâce à la présence du composant de contrôle 8, et, d'autre part, la fonction de mesure, grâce à la présence du moyen de mesure électrique 10. La carte fille 11 et ses composants peuvent être assemblés indépendamment en un ensemble de contrôle et de mesure 13, placé ultérieurement sur la carte mère 9.

On réalise donc le montage, sur une carte fille 11, du moyen de mesure électrique 10 et du composant de contrôle 8, la carte fille 11 étant placée sur une carte mère 9, en lui étant perpendiculaire. Ce montage permet ainsi de réaliser de façon très compacte les fonctions de transmission contrôlée et de mesure, tout en conservant une architecture où la première borne 4 et la deuxième borne 5 se font face.

La carte mère 9 et la carte fille 11 présentent donc une connexion électrique de l'une à l'autre supplémentaire, permettant de faire circuler un courant de commande depuis la partie de contrôle 7 sur la carte mère 9 vers le composant de contrôle 8, monté sur la carte fille 11. Là aussi, cette connexion électrique peut s'effectuer par soudure de leurs pistes respectives ou par un élément conducteur intermédiaire.

Dans des modes de réalisation particuliers, le moyen de mesure électrique 10 prend essentiellement la forme d'un tore 14 de mesure, dans lequel se trouve un conducteur appartenant à la ligne de puissance 3. Afin d'effectuer la mesure, le tore 14 doit être traversé par un conducteur dans lequel circule le courant de puissance, c'est-à-dire préférentiellement un conducteur monté en série dans la ligne de puissance 3. Afin de renvoyer un signal représentatif de la mesure, il doit bien entendu être relié électriquement pour une sortie de courant. Ainsi, dans l'absolu, le conducteur qui traverse le tore peut être relié électriquement n'importe où entre la première borne 4 et la deuxième borne 5, et donc sur la carte mère 9, la carte fille 11, voire les bornes elles-mêmes. La connexion de la sortie du tore 14, en direction de la partie de contrôle 7, peut se faire par une liaison électrique directement avec la carte mère 9, ou à travers la carte fille 11. La partie de contrôle 7 sert donc non seulement au pilotage du au moins un composant de contrôle 8, mais aussi au transfert, voire au traitement, de l'information issue de la mesure.

Dans les figures, le tore 14 est monté comme un composant de la carte fille 11, et le courant qu'il produit lui est donc directement fourni. Le lien électrique entre les pistes des cartes mère 9 et fille 11 permet de faire circuler dans la carte mère 9 le courant représentatif de celui circulant dans la ligne de puissance 3 surveillée, et généré par le tore lui-même. Les pistes auxquelles le tore 14 est relié sur la carte fille 11 sont donc reliées électriquement à des pistes dédiées sur la carte mère 9, faisant partie de la partie de contrôle 7.

Ainsi, selon une caractéristique additionnelle possible, la sortie du tore 14 de mesure est reliée à la carte fille 11, elle-même reliée à la carte mère 9, portant elle-même les éléments essentiels de la partie de contrôle 7 aptes à traiter le signal généré par ledit tore 14.

Selon une autre caractéristique additionnelle possible, la au moins une ligne de puissance 3 comprend un conducteur filaire 12 qui traverse le tore 14, notamment un conducteur filaire 12 rigide. Le conducteur filaire 12 est donc connecté dans la ligne de puissance 3 en série avec le composant de contrôle 8, entre la première borne 4 et la deuxième borne 5. Préférentiellement, le conducteur filaire 12 est relié par soudure, pour une de ses extrémités, à la carte mère 9, et, pour l'autre, à la carte fille 11. La ligne de puissance 3 peut donc passer par la première borne 4, une piste de la carte mère 9, la soudure entre la carte mère 9 et la carte fille 11, une piste de la carte fille 11, un conducteur 12 soudé à la piste et traversant le tore 14 de mesure, puis une piste de la carte mère 9 à laquelle le conducteur 12 est soudé, puis enfin la deuxième borne 5. Un montage dans le sens opposé est bien entendu aussi possible.

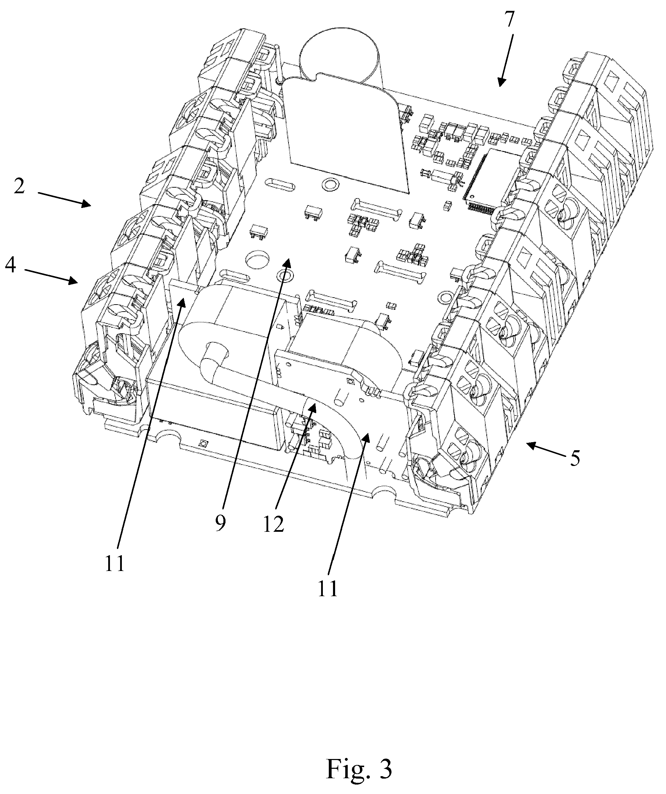

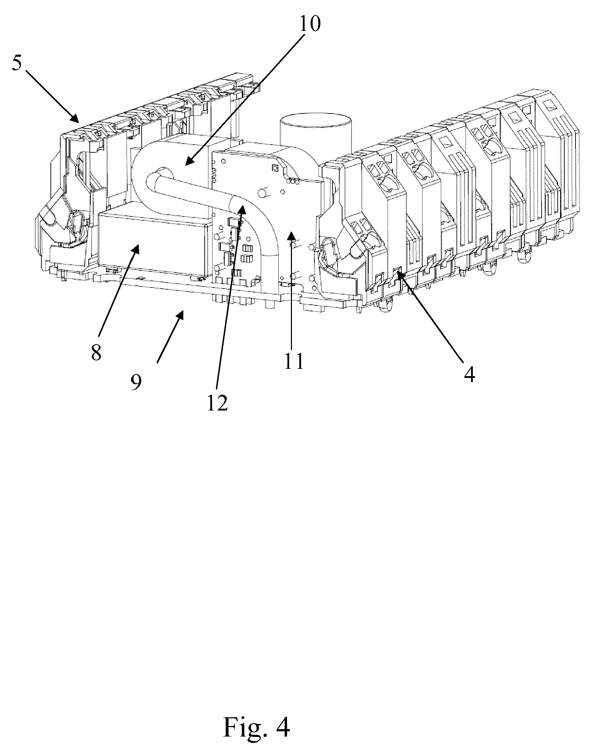

Ainsi, dans des réalisations particulières, la carte fille 11 accueille, d'une part, le tore 14 de mesure à laquelle il est soudé, pour recevoir le signal qu'il génère, et, d'autre part, un conducteur filaire 12 le traversant et soudé pour une de ses extrémités à une piste de la carte mère 9 transmettant la puissance, voire accueille aussi le composant de contrôle 8, comme le montrent les figures 3 et 4. La carte fille 11 forme donc, avec ses composants, un ensemble de contrôle et de mesure 13 qui peut être fabriqué de façon autonome et implanté entre la première borne 4 et la deuxième borne 5, en réalisant la soudure entre les cartes, leurs pistes, ainsi que la soudure entre le conducteur filaire 12 et une piste de la carte mère 9.

Pour monter la carte fille 11, munie de ses composants, sur la carte mère 9, il suffira alors de les relier mécaniquement au niveau de leur arête commune, de relier aussi électriquement par là leurs pistes, puis de relier le conducteur filaire 12, formant la sortie ou l'entrée de puissance dans la carte fille 11, à une piste de puissance de la carte mère 9.

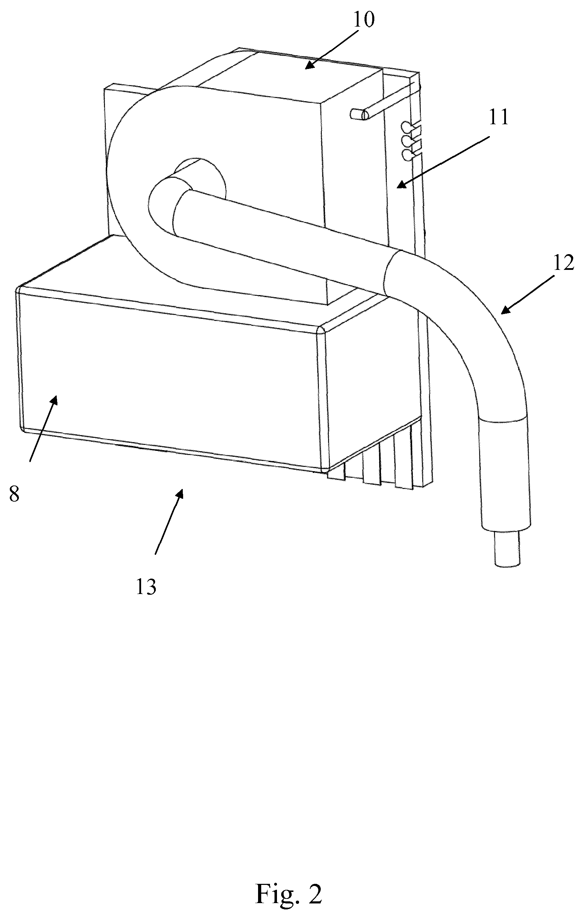

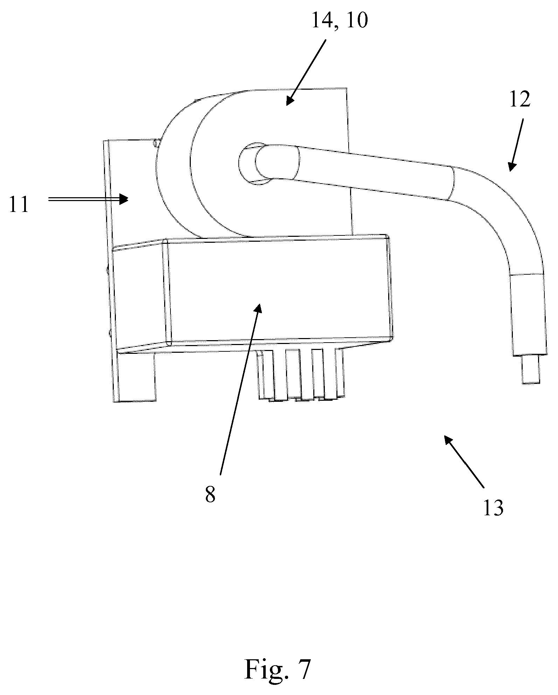

Dans le mode de réalisation illustré dans les figures 2 à 7, pour la ou chaque ligne de puissance 3,
la carte mère 9 est reliée électriquement à la première borne 4 et à la deuxième borne 5 et porte des pistes pour la circulation du courant de puissance,
la carte fille 11, le conducteur filaire 12, le moyen de mesure électrique 10 et le composant de contrôle 8 formant un ensemble de contrôle et de mesure 13, la carte fille 11 étant placée perpendiculairement à la carte mère 9 et soudée à elle au niveau de leur arête commune, pour une liaison électrique permettant
- une circulation du courant de puissance pour qu'il traverse la carte fille 11 lorsqu'il circule de la première borne 4 vers la deuxième borne 5, grâce à leurs pistes respectives, éventuellement aussi grâce au conducteur filaire 12 monté entre elles,
- une circulation du courant de contrôle pilotant le composant de contrôle 8, grâce à une soudure de leurs pistes respectives, et
- une circulation du courant de signal représentant le signal généré par le moyen de mesure électrique 10, grâce à des pistes de la partie de contrôle 7.

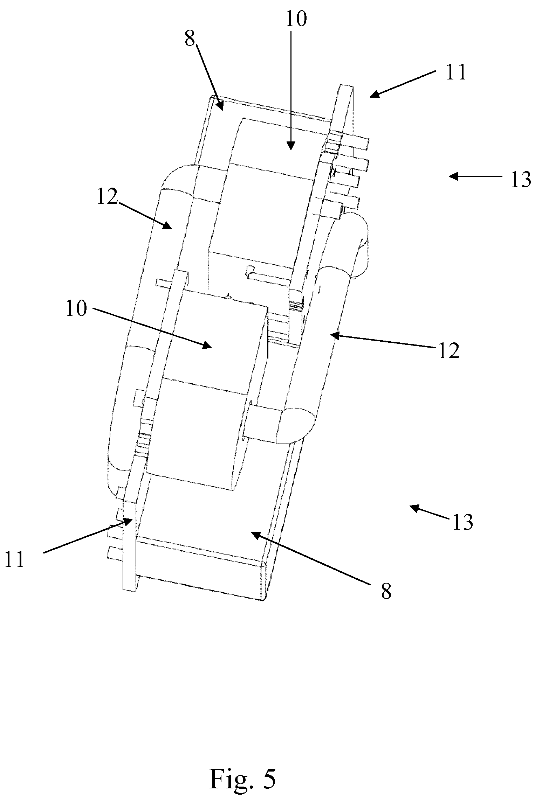

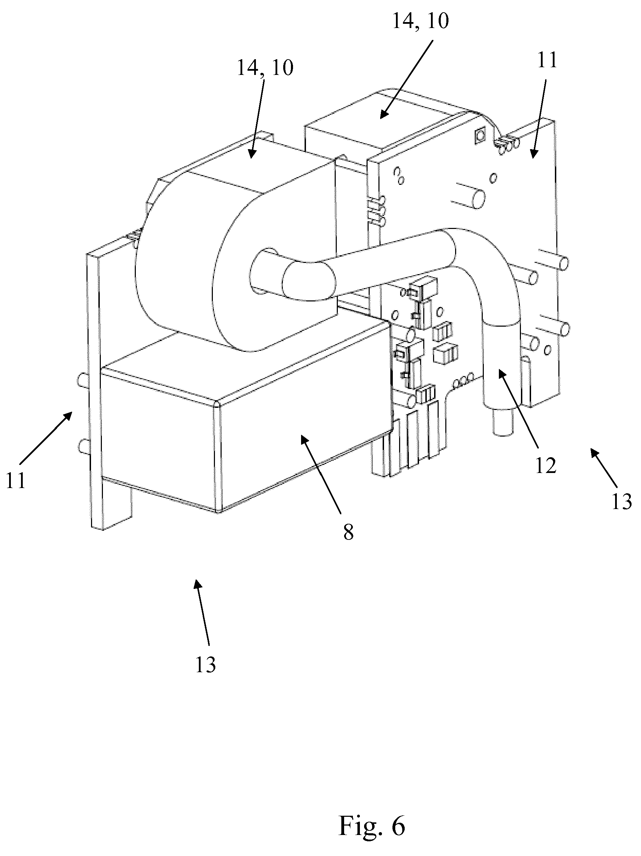

En outre, dans des applications particulières, illustrées figure 5 et 6, le module domotique 1 comprend au moins une paire de lignes de puissance 3, dont les premières bornes 4 sont alignées côte à côte, d'une part, comme les deuxièmes bornes 5, d'autre part, chaque ligne de puissance 3 présentant un ensemble de contrôle et de mesure 13, leurs ensembles étant placés tête bêche, de sorte que, pour l'un, la carte fille 11, munie du composant de contrôle 8 et du moyen de mesure électrique 10, se trouve à proximité de la première borne 4 alors que pour l'autre, tournée de 180°, elle se trouve à proximité de la deuxième borne 5,
le conducteur filaire 12 de l'un de ces ensembles étant relié à une piste de la carte de mère 9 qui passe transversalement sous la carte fille 11 de l'autre.

Le module domotique 1 présente généralement une pluralité de lignes de puissance 3 alignées les unes à côté des autres. Ainsi, une certaine largeur du module domotique 1 peut être utilisée pour les composants de chacune de ces lignes. La carte fille 11 s'étend ainsi préférentiellement le long d'un des côtés de l'espace réservé à la ligne de puissance 3, de sorte que les composants les plus volumineux qu'elle présente, à savoir le moyen de mesure électrique 10, voire le composant de contrôle 8, puissent s'étendre sur une grande partie de la largeur dédiée à la ligne de puissance 3. La figure 4 en particulier montre par ailleurs que le composant de contrôle 8 peut se trouver entre le moyen de mesure électrique 10, à savoir le tore 14, et la carte mère 9.

Le conducteur filaire 12 s'étend lui aussi à partir d'une première extrémité depuis la carte fille 11 en direction du côté opposé de l'espace réservé à la ligne de puissance 3, de sorte à traverser le tore 14 de mesure, son autre extrémité étant ramenée dans la carte mère 9, entre la carte fille 11 et soit la première borne 4 soit la deuxième borne 5, contournant ainsi le composant de contrôle 8.

Le montage tête bêche permet en particulier d'optimiser l'espace afin de libérer de la place pour d'autres composants du module domotique 1 et permet aussi d'utiliser deux cartes fille 11 de conception similaire. Il est ainsi possible d'utiliser des ensembles de contrôle et de mesure 13 de conception similaire, qui sont suffisamment compacts pour être placés dans l'alignement l'un de l'autre, chacun dépassant légèrement jusqu'à venir entre les bornes 4, 5 de l'autre ligne de puissance 3, comme le montre la figure 3. Les ensembles de contrôle et de mesure 13 de deux lignes de puissance 3 adjacentes s'étalent donc en largeur le long de deux premières bornes 4, ou de deux deuxièmes bornes 5. Ils peuvent être montés l'un à la suite de l'autre entre une première borne 4 et la deuxième borne 5 correspondante.

Bien entendu, l'invention n'est pas limitée au mode de réalisation décrit et représenté aux dessins annexés. Des modifications restent possibles, notamment du point de vue de la constitution des divers éléments, par combinaison différente de tout ou partie des caractéristiques décrites ci-dessus, ou encore par substitution d'équivalents techniques, sans sortir pour autant du domaine de protection de l'invention.

## Revendications

1. Module domotique (1), présentant, d'une part, une partie puissance (2) comprenant au moins une ligne de puissance (3) ayant, pour sa connexion, une première borne (4) et une deuxième borne (5), et, d'autre part, une partie de contrôle (7) pour piloter au moins un composant de contrôle (8), type relais, monté dans la ligne de puissance (3) et en influençant l'état électrique, en particulier l'état passant ou non,
module domotique (1) **caractérisé en ce que**
la première borne (4) et la deuxième borne (5) sont positionnées en vis-à-vis l'une de l'autre sur des faces opposées du module domotique (1), le module domotique (1) comprenant, pour la au moins une ligne de puissance (3), un moyen de mesure électrique (10) monté dans la au moins une ligne de puissance (3) entre la première borne (4) et la deuxième borne (5).

2. Module domotique (1) selon la revendication 1, **caractérisé en ce que**
il comprend une première carte de circuit imprimée, dite carte mère (9), portant tout ou partie des composants électroniques du module domotique (1) ainsi que des pistes électriques pour la au moins une ligne de puissance (3) et des pistes électrique pour la partie de contrôle (7),
le moyen de mesure électrique (10) étant monté sur une deuxième carte de circuit imprimé, dite carte fille (11), que comprend le module domotique (1) et s'étendant perpendiculairement à la carte mère (9).

3. Module domotique (1) selon la revendication 2, **caractérisé en ce que**
le composant de contrôle (8) est lui aussi monté sur la carte fille (11), la carte mère (9) et la carte fille (11) étant, en outre, reliées électriquement pour la circulation de la commande dudit composant de contrôle (8) à l'aide de la partie de contrôle (7).

4. Module domotique (1) selon l'une quelconque des revendications 1 à 3, **caractérisé en ce que**
le moyen de mesure électrique (10) prend essentiellement la forme d'un tore (14) de mesure, dans lequel se trouve un conducteur appartenant à la ligne de puissance (3).

5. Module domotique (1) selon la revendication 4, **caractérisé en ce que** la au moins une ligne de puissance (3) comprend un conducteur filaire (12) qui traverse le tore (14).

6. Module domotique (1) selon la revendication 5, **caractérisé en ce que**
le conducteur filaire (12) est relié par soudure, pour une de ses extrémités, à la carte mère (9), et, pour l'autre, à la carte fille (11).

7. Module domotique (1) selon l'une quelconque des revendications 2 ou 3 et selon l'une quelconque des revendications 4 à 6, **caractérisé en ce que**
la sortie du tore (14) de mesure est reliée à la carte fille (11), elle-même reliée à la carte mère (9), portant elle-même les éléments essentiels de la partie de contrôle (7) aptes à traiter le signal généré par ledit tore (14).

8. Module domotique (1) selon la revendication 3, selon la revendication 6 et selon la revendication 7, **caractérisé en ce que**, pour la ou chaque ligne de puissance (3),
la carte mère (9) est reliée électriquement à la première borne (4) et à la deuxième borne (5) et porte des pistes pour la circulation du courant de puissance,
la carte fille (11), le conducteur filaire (12), le moyen de mesure électrique (10) et le composant de contrôle (8) formant un ensemble de contrôle et de mesure (13), la carte fille (11) étant placée perpendiculairement à la carte mère (9) et soudée à elle au niveau de leur arête commune, pour une liaison électrique permettant
- une circulation du courant de puissance pour qu'il traverse la carte fille (11) lorsqu'il circule de la première borne (4) vers la deuxième borne (5), grâce à leurs pistes respectives, éventuellement aussi grâce au conducteur filaire (12) monté entre elles,
- une circulation du courant de contrôle pilotant le composant de contrôle (8), grâce à une soudure de leurs pistes respectives, et
- une circulation du courant de signal représentant le signal généré par le moyen de mesure électrique (10), grâce à des pistes de la partie de contrôle (7).

9. Module domotique (1) selon la revendication 8, **caractérisé en ce que**
il comprend au moins une paire de lignes de puissance (3), dont les premières bornes (4) sont alignées côte à côte, d'une part, comme les deuxièmes bornes (5), d'autre part, chaque ligne de puissance (3) présentant un ensemble de contrôle et de mesure (13), leurs ensembles étant placés tête bêche, de sorte que, pour l'un, la carte fille (11), munie du composant de contrôle (8) et du moyen de mesure électrique (10), se trouve à proximité de la première borne (4) alors que pour l'autre, tournée de 180°, elle se trouve à proximité de la deuxième borne (5),
le conducteur filaire (12) de l'un de ces ensembles étant relié à une piste de la carte de mère (9) qui passe transversalement sous la carte fille (11) de l'autre.

## Patentansprüche

1. Hausautomatisierungsmodul (1), umfassend einerseits ein Leistungsteil (2), welches wenigstens eine Leistungsleitung (3) umfasst, die für ihre Verbindung einen ersten Anschluss (4) und einen zweiten Anschluss (5) aufweist, und andererseits ein Steuerteil (7) zum Steuern wenigstens eines Steuerelements (8) des Typs Relais, welches in der Leistungsleitung (3) angeordnet ist und dabei den elektrischen Zustand, insbesondere den Zustand leitend oder nicht leitend, beeinflusst, wobei das Hausautomatisierungsmodul (1) **dadurch gekennzeichnet ist, dass** der erste Anschluss (4) und der zweite Anschluss (5) auf entgegengesetzt liegenden Seiten des Hausautomatisierungsmoduls vis-à-vis zueinander angeordnet sind, wobei das Hausautomatisierungsmodul (1) für die wenigstens eine Leistungsleitung (3) eine elektrische Messvorrichtung (10) umfasst, die in der wenigstens einen Leistungsleitung (3) zwischen dem ersten Anschluss (4) und dem zweiten Anschluss (5) angeordnet ist.

2. Hausautomatisierungsmodul (1) nach Anspruch 1, **dadurch gekennzeichnet, dass** es eine erste Leiterplatte, sogenannte Hauptplatine (9) umfasst, die ganz oder teilweise die elektronischen Bauelemente des Hausautomatisierungsmoduls (1), die elektrischen Pfade für die wenigstens eine Leistungsleitung (3) sowie die elektrischen Pfade für das Steuerteil (7) umfasst, wobei die elektrische Messvorrichtung (10) auf einer zweiten Leiterplatte, sogenannte Tochterplatine (11), welche das Hausautomatisierungsmodul (1) umfasst und sich senkrecht zu der Hauptplatine (9) erstreckt, montiert ist.

3. Hausautomatisierungsmodul (1) nach Anspruch 2, **dadurch gekennzeichnet, dass** das Steuerelement (8) auch auf der Tochterplatine (11) montiert ist, wobei die Hauptplatine (9) und die Tochterplatine (11) darüber hinaus für den Umlauf der Befehle des Steuerelements (8) mittels des Steuerteils (7) elektrisch verbunden sind.

4. Hausautomatisierungsmodul (1) nach einem der Ansprüche 1 bis 3, **dadurch gekennzeichnet, dass** die elektrische Messvorrichtung (10) im Wesentlichen die Form eines Messtorus (14) aufweist, in dem sich ein Leiter befindet, der zu der Leistungsleitung (3) gehört.

5. Hausautomatisierungsmodul (1) nach Anspruch 4, **dadurch gekennzeichnet, dass** die wenigstens eine Leistungsleitung (3) einen Kabelleiter (12) umfasst, welcher den Torus (14) durchdringt.

6. Hausautomatisierungsmodul (1) nach Anspruch 5, **dadurch gekennzeichnet, dass** der Kabelleiter (12) mit einem seiner Enden mit der Hauptplatine (9) und mit dem anderen Ende mit der Tochterplatine (11) durch Löten verbunden ist.

7. Hausautomatisierungsmodul (1) nach einem der Ansprüche 2 oder 3 und nach einem der Ansprüche bis 4 bis 6, **dadurch gekennzeichnet, dass** der Ausgang des Messtorus (14) mit der Tochterplatine (11) verbunden ist, die selbst mit der Hauptplatine (9) verbunden ist, welche selbst die wesentlichen Elemente des Steuerteils (7) trägt, die ausgelegt sind, um das vom Torus (14) erzeugte Signal zu verarbeiten.

8. Hausautomatisierungsmodul (1) nach Anspruch 3, nach Anspruch 6 und nach Anspruch 7, **dadurch gekennzeichnet, dass** für die oder jede Leistungsleitung (3) die Hauptplatine (9) elektrisch mit dem ersten Anschluss (4) und dem zweiten Anschluss (5) verbunden ist und Pfade für den Umlauf des Leistungsstroms trägt, die Tochterplatine (11), der Kabelleiter (12), die elektrische Messvorrichtung (10) und das Steuerelement (8) eine Anordnung zum Steuern und Messen (13) bilden, wobei die Tochterplatine (11) senkrecht zu der Hauptplatine (9) angeordnet ist und im Bereich ihrer gemeinsamen Kante an dieser angelötet ist, um eine elektrische Verbindung herzustellen, die ermöglicht:
- einen Umlauf des Leistungsstrom, damit dieser, während er aufgrund ihrer entsprechenden Pfade und gegebenenfalls auch aufgrund des Kabelleiters (12), der zwischen diesen angeordnet ist, von dem ersten Anschluss (4) zu dem zweiten Anschluss (5) fließt, durch die Tochterplatine (11) hindurchgeht,
- einen Umlauf des Steuerstroms, der das Steuerelement (8) steuert, aufgrund einer Verlötung ihrer entsprechenden Pfade, und
- einen Umlauf von Signalstrom, der das Signal darstellt, welches durch die Messvorrichtung (10) erzeugt wurde, aufgrund der Pfade des Steuerteils (7).

9. Hausautomatisierungsmodul (1) nach Anspruch 8, **dadurch gekennzeichnet, dass** es wenigstens ein Paar Leistungsleitungen (3) umfasst, von denen einerseits die ersten Anschlüsse (4) und andererseits die zweiten Anschlüsse (5) nebeneinander angeordnet sind, wobei jede Leistungsleitung (3) eine Anordnung zum Steuern und Messen (13) umfasst, wobei deren Anordnungen entgegengesetzt angeordnet sind, so dass für eine die Tochterplatine (11), die mit dem Steuerelement (8) und der elektrischen Messvorrichtung (10) versehen ist, sich in der Nähe des ersten Anschlusses (4) befindet, während sie sich für die andere um 180° gedreht in der Nähe des zweiten Anschlusses (5) befindet, wobei der Kabelleiter (12) von einer dieser Anordnungen mit einem Pfad der Hauptplatine (9) verbunden ist, der quer unter der Tochterplatine (11) der anderen hindurchgeht.

## Claims

1. Home-automation module (1), comprising on the one hand a power element (2) comprising at least one power line (3) having for its connection a first terminal (4) and a second terminal (5), and on the other hand a control element (7) for driving at least one control component (8) of the relay type mounted in the power line (3) and influencing the electrical state, in particular the switched on or not switched on state,
the home-automation module (1) being **characterised in that** the first terminal (4) and the second terminal (5) are positioned opposite one another on opposite faces of the home-automation module (1), the home-automation module (1) comprising, for the at least one power line (3), an electrical measuring means (10) mounted in the at least one power line (3) between the first terminal (4) and the second terminal (5).

2. Home-automation module (1) according to claim 1, **characterised in that** it comprises a first printed circuit board, referred to as the motherboard (9), comprising all or a portion of the electronic components of the home-automation module (1) as well as electric tracks for the at last one power line (3) and electric tracks for the control element (7), the electrical measuring device (10) being mounted on a second printed circuit board, referred to as a daughter board (11), comprised in the home-automation module (1) and extending perpendicularly to the motherboard (9).

3. Home-automation module (1) according to claim 2, **characterised in that** the control component (8) is itself mounted on the daughter board (11), the motherboard (9) and the daughter board (11) also being connected electrically for the circulation of the control of said control component (8) by means of the control element (7).

4. Home-automation module (1) according to any one of claims 1 to 3, **characterised in that** the electrical measuring device (10) has essentially the form of a measuring torus (14), in which a conductor is located belonging to the power line (3).

5. Home-automation module (1) according to claim 4, **characterised in that** the at least one power line (3) comprises a wired conductor (12) which traverses the torus (14).

6. Home-automation module (1) according to claim 5, **characterised in that** the wired conductor (12) is connected by welding at one of its ends to the motherboard (9) and at the other end to the daughter board (11).

7. Home-automation module (1) according to any one of claims 2 or 3 and according to any one of claims 4 to 6, **characterised in that** the output of the measuring torus (14) is connected to the daughter board (11), itself connected to the motherboard (9) and comprising the essential elements of the control element (7) able to process the signal generated by said torus (14).

8. Home-automation module (1) according to claim 3, according to claim 6 and according to claim 7, **characterised in that** for the or each power line (3), the motherboard (9) is connected electrically to the first terminal (4) and to the second terminal (5) and comprises tracks for the circulation of the power current, the daughter board (11), the wired conductor (12), the electrical measuring device (10) and the control component (8) forming a control and measuring assembly (13), the daughter board (11) being placed perpendicular to the motherboard (9) and welded to the latter at their common edge for an electrical connection enabling
- the circulation of the power current so that it traverses the daughter board (11) when it circulates from the first terminal (4) towards the second terminal (5), by means of their respective tracks, possibly also by means of a wired conductor (12) mounted between them,
- the circulation of the control current driving the control component (8), by welding their respective tracks, and
- the circulation of the signal current representing the signal generated by the electrical measuring device (10), by means of tracks from the control element (7).

9. Home-automation module (1) according to claim 8, **characterised in that** it comprises at least one pair of power lines (3), the first terminals (4) of which are on the one hand aligned side by side like the second terminals (5) on the other hand, each power line (3) having a control and measuring assembly (13), their assemblies being placed head to tail such that for one the daughter board (11) equipped with the control component (8) and the electric measuring device (10) is located close to the first terminal (4) whereas for the other, turned by 180°, it is located close to the second terminal (5),
the wired conductor (12) of one of these assemblies being connected to a track of the mother board (9) which passes transversely below the daughterboard (11) of the other.
